# EUROPÄISCHE PATENTSCHRIFT

(11) **EP 2 121 387 B1**
(45) Veröffentlichungstag und Bekanntmachung des Hinweises auf die Patenterteilung: **10.01.2018**
(21) Anmeldenummer: 08734368.7
(22) Anmeldetag: 11.03.2008
(51) Int. Cl.: B60R 16/023, F16H 61/00

(54) **MASSEBONDVERBINDUNG**
GROUND BONDING CONNECTION
CONNEXION DE MISE À LA MASSE

(30) Priorität: 19.03.2007 DE 102007014277
(43) Veröffentlichungstag der Anmeldung: 25.11.2009
(73) Patentinhaber: Conti Temic Microelectronic GmbH, 90411 Nürnberg (DE)
(72) Erfinder: KARRER, Helmut, 90762 Fürth (DE); BAUER, Gerhard, 91322 Gräfenberg (DE); VÖGERL, Andreas, 92331 Parsberg (DE); WIECZOREK, Matthias, 91223 Neunkirchen am Sand (DE); HENNIGER, Jürgen, 91056 Erlangen-Dechsendorf (DE); WENK, Alexander, 91595 Burgoberach (DE); ALBERT, Andreas, 91315 Höchstadt/Aisch (DE); OED, Harald, 90482 Nürnberg (DE); URBANEK, Thomas, 91126 Schwabach (DE); BUHL, Joachim, 90482 Nürnberg (DE); FALKNER, Roland, 91220 Schnaittach (DE); HIRMER, Christian, 91058 Erlangen (DE)
(74) Vertreter: Bonn, Roman Klemens
(86) Internationale Anmeldenummer: PCT/DE2008/000428
(87) Internationale Veröffentlichungsnummer: WO 2008/113323

(56) Entgegenhaltungen:
- EP-A- 1 677 583

## Beschreibung

Die Erfindung betrifft ein Steuergerät für ein Kraftfahrzeug sowie ein Verfahren zur Herstellung eines Potentialausgleichs in einem solchen Steuergerät. Das gattungsbildende Dokument EP 1 677 583A offenbart den Oberbegriff des Anspruchs 1.

Für ein Steuergerät in einem Kraftfahrzeug ist aus Gründen der elektromagnetischen Verträglichkeit eine Masseanbindung des Schaltungsträgers des Steuergeräts zur Steuergerätgrundplatte, welche üblicherweise aus Aluminium ist, notwendig.
Ein Massebond ist aus Gründen der elektromagnetischen Verträglichkeit erforderlich, um den Masseversatz zwischen dem Getriebegehäuse, d. h. der Masse am Fahrzeug und dem Steuergerät auszugleichen. Masse bezeichnet hierbei das elektrische Bezugspotential für Signal- und Betriebsspannungen im Fahrzeug bzw. Steuergerät. Bisher ist hierzu eine direkte Bondverbindung vom Schaltungsträger auf die Grundplatte des Steuergeräts aus Aluminium vorgesehen. Hierzu muss die Bondfläche mechanisch bearbeitet sein. Dies verursacht zusätzliche Kosten, da hier sonst keine Bearbeitung notwendig ist. Eine Schwierigkeit besteht darin, dass die Bondfläche Verschmutzungen aufweisen kann, und somit keine sichere Bondverbindung gewährleistet ist, was Reparaturen notwendig macht. Üblicherweise wird der Massebond direkt auf die Aluminium-Druckguss-Grundplatte gesetzt. Um die Bondbarkeit auf der Grundplatte zu gewährleisten, ist eine mechanisch bearbeitete Fläche erforderlich. Insbesondere muss die Grundplatte mit Perchlorethylen gewaschen, insbesondere entfettet werden, um den strengen Sauberkeits- und Oberflächenanforderungen zu genügen. Dies ist ein teures und umweltschädliches Verfahren.

Der Erfindung liegt daher die Aufgabe zugrunde, ein Steuergerät für ein Kraftfahrzeug zu schaffen, bei welchem die Masseanbindung des Schaltungsträgers zum Getriebegehäuse vereinfacht ist.

Diese Aufgabe wird durch die Merkmale der Ansprüche 1 und 7 gelöst.

Beim Steuergerät gemäß Anspruch 1 ist somit eine spezielle Reinigung der Steuergerätgrundplatte nicht nötig.
Eine flexible Ausbildung der Leiterstruktur gemäß Anspruch 2 ermöglicht ein einfaches und robustes Anordnen derselben im Steuergerät. Folienleiter gemäß Anspruch 3 stellen eine besonders robuste und vielseitige Form einer flexiblen Leiterstruktur dar.
Dadurch, dass die Trägerstruktur gemäß Anspruch 4 Teil des Gehäuses des Steuergeräts ist, wird ein Potentialausgleich zwischen dem Schaltungsträger und dem gesamten Gehäuse sichergestellt.
Eine mechanische Verbindung zwischen der Leiterstruktur und dem Steuergerätgehäuse gemäß Anspruch 5 führt zu einer erhöhten Belastbarkeit.

Den Schaltungsträger gemäß Anspruch 6 als Leiterplatte auszubilden ist besonders platzsparend.

Zusätzliche Merkmale und Einzelheiten der Erfindung ergeben sich aus der Beschreibung von Ausführungsbeispielen anhand der Zeichnungen. Es zeigen:
- Fig. 1: einen Teilquerschnitt einer ersten Ausführungsform der Erfindung,
- Fig. 2: einen Teilquerschnitt gemäß einer weiteren Ausführungsform der Erfindung,
- Fig. 3: einen Teilquerschnitt gemäß einer dritten Ausführungsform der Erfindung,
- Fig. 4: eine Teilansicht eines erfindungsgemäßen Folienleiters,
- Fig. 5: eine Ansicht eines Nietauges eines Folienleiters gemäß Fig. 4 und
- Fig. 6: ein weiteres Beispiel eines Nietauges eines Folienleiters gemäß Fig. 4.

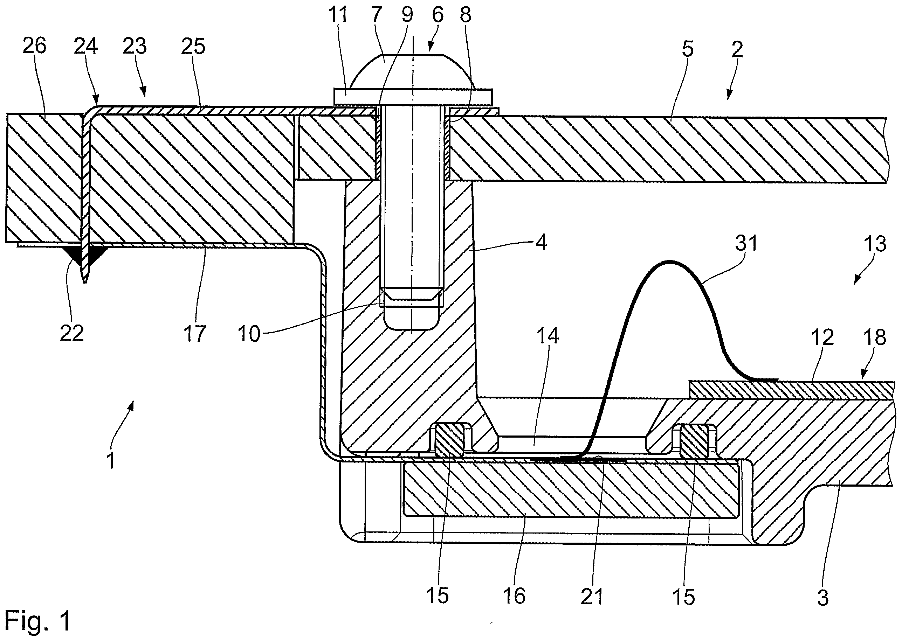

Ein Steuergerät 1 für ein Kraftfahrzeug, insbesondere ein Getriebesteuergerät umfasst gemäß Fig. 1 ein Gehäuse 2 zur Aufnahme eines elektrischen Bauteils 18 mit einer Grundplatte 3, mindestens einer Seitenwand 4 und einem Deckel 5.

Die Grundplatte 3 kann einteilig mit der Seitenwand 4 ausgebildet sein. Der Deckel 5 ist fest, insbesondere dicht, vorzugsweise flüssigkeits- und/oder gasdicht mit dem Rest des Gehäuses 2 verbunden. Der Deckel 5 ist hierzu mittels einer Schraube 6 mit einem Schraubenkopf 7 mit der Seitenwand 4 des Gehäuses 2 verschraubt. Die Schraube 6 ist durch eine Bohrung 8 im Deckel 5, in welcher eine Hülse 9 vorgesehen ist, hindurchgeführt und greift in ein Gewinde 10 in der Seitenwand 4 des Gehäuses 2 ein. Zwischen dem Schraubenkopf 7 und dem Deckel 5 ist eine Zwischenlegscheibe 11 vorgesehen.

Die Schraube 6 ist aus einem elektrisch leitfähigen Material, insbesondere aus Metall. Die Zwischenlegscheibe 11 ist ebenfalls aus einem elektrisch leitfähigen Material, insbesondere aus Metall. Vorteilhafterweise ist auch die Hülse 9 aus einem elektrisch leitfähigen Material, insbesondere aus Metall.

Der Deckel 5 kann jedoch auch auf alternative Weise mit dem Rest des Gehäuses 2 verbunden sein, beispielsweise mittels einer Nietverbindung und/oder einer Steckverbindung. Er kann ebenso mit dem Rest des Gehäuses 2 verklebt oder verschweißt sein. Der Deckel 5 ist formstabil. Er ist beispielsweise aus Kunststoff. Er kann jedoch ebenso aus Metall, beispielsweise aus Aluminium sein. Ebenso ist die Seitenwand 4 formstabil, beispielsweise aus Kunststoff oder Metall. Das Gehäuse 2 ist somit formstabil ausgebildet und zumindest teilweise aus Kunststoff und/oder Aluminium. Es umschließt einen Gehäuseinnenraum 13 dicht, insbesondere flüssigkeits- und/oder gasdicht. Es weist mindestens eine Durchführöffnung 14 für eine Leiterstruktur 17 auf, welche ebenfalls dicht nach außen abgeschlossen ist. Hierfür sind als Dichtungsring 15 ausgebildete Dichtungsmittel und eine Andruckplatte 16 vorgesehen.

Die Grundplatte 3, welche eine Trägerstruktur für einen auf ihr angeordneten Schaltungsträger 12 bildet, ist ebenfalls formstabil, insbesondere aus Aluminium, insbesondere eine Aluminium-Druckguss-Platte. Der Schaltungsträger 12 umfasst eine Leiterplatte mit einem Keramiksubstrat. Die Leiterplatte umfasst eine Hybridschaltung. Alternative Leiterplatten sind jedoch ebenfalls möglich.

Das Steuergerät 1 umfasst weiterhin die Leiterstruktur 17, welche in datenübertragender Weise mit dem elektrischen Bauteil 18 verbunden ist. Das elektrische Bauteil 18 kann beispielsweise Sensoren und/oder Aktoren umfassen. Die Leiterstruktur 17 ist vorteilhafterweise flexibel ausgebildet. Sie ist insbesondere als Folienleiter ausgebildet. Sie ist somit sehr robust und besonders platzsparend ausgebildet. Zur Verbindung des elektrischen Bauteils 18 im Gehäuseinnenraum 13 ist der Folienleiter zwischen dem Dichtungsring 15 und der Andruckplatte 16 abgedichtet durch die Durchführöffnung 14 hindurch geführt.

Der Folienleiter umfasst eine dünne, folienartig ausgebildete Flexleiterplatte 19, beispielsweise auf Basis einer Polyimid-Folie. Auf dieser ist mindestens eine, insbesondere eine Vielzahl von Leiterbahnen 20 angeordnet. Die Leiterbahnen 20 sind elektrisch leitend, jedoch jeweils voneinander elektrisch isoliert. Sie sind aus einem elektrisch leitfähigen Material, insbesondere aus Kupfer bzw. einer Kupferlegierung und weisen an ihren Enden jeweils eine Kontaktstelle 21, 22 auf. Die erste Kontaktstelle 21 jeder Leiterbahn 20 ist jeweils im Gehäuseinnenraum 13 angeordnet. Sie dient der Daten- und/oder Stromverbindung zum elektrischen Bauteil 18 im Gehäuseinnenraum 13. Mittels der zweiten Kontaktstelle 22 ist jede Leiterbahn 20 jeweils außerhalb des Gehäuses 2 verbindbar. Hierzu ist insbesondere eine Schnittstelle 23 mit einem Stanzgitter 24 vorgesehen, wobei das Stanzgitter 24 eine Vielzahl von Kontaktstiften 25 aus Metall aufweist, welche mit Kunststoff 26 umspritzt sind. Anstelle des Kunststoffes 26 kann auch ein anderes formstabiles, elektrisch isolierendes Material, beispielsweise Harz vorgesehen sein. Die Kontaktstifte 25 ragen an ihren Enden jeweils aus dem Kunststoff 26 heraus. Sie sind somit elektrisch kontaktierbar. Die Schnittstelle 23 ist fest mit dem Gehäuse 2 verbunden, beispielsweise verklebt, verpresst oder verstemmt.

Die Kontaktstifte 25 sind zumindest teilweise mit den zweiten Kontaktstellen 22 der Leiterbahnen 20 elektrisch verbunden, beispielsweise verlötet. Die elektrische Verbindung zwischen der Schnittstelle 23 und dem Folienleiter kann jedoch auch auf alternative Weise, beispielsweise durch flächigen Kontakt zwischen jeweils einem der Kontaktstifte 25 und einer der Kontaktstellen 22 oder als Steckkontakt zwischen diesen hergestellt sein. Eine Lötverbindung ist jedoch besonders vorteilhaft, da sie sehr robust ist und einen sicheren elektrischen Kontakt gewährleistet.

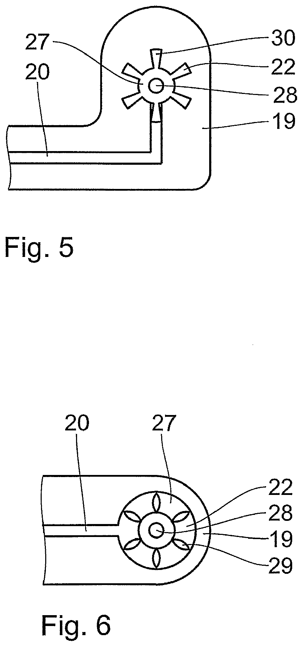

Die Kontaktstellen 21, 22, insbesondere die zweiten Kontaktstellen 22 sind vorteilhafterweise ringförmig mit einem elektrisch leitenden Ring 27 um eine zentrale Aussparung 28 ausgebildet. Der Ring kann wie in den Figuren 5 und 6 dargestellt insbesondere wellenförmig oder fächerförmig angeprägt sein, d. h. Anprägungen 29 oder fächerförmige Fortsätze 30 aufweisen. Hierdurch wird insbesondere im Falle eines Klemm- und/oder Steckkontaktes der elektrische Kontakt zur zweiten Kontaktstelle 22 verbessert. Der Folienleiter weist mindestens eine Leiterbahn 20 auf, welche mit dem Schaltungsträger 12 einerseits und dem Gehäuse 2 andererseits elektrisch verbunden ist und dadurch einen Potentialausgleich, insbesondere eine Masseanbindung zwischen diesen ermöglicht. Hierzu ist diese Leiterbahn 20 mittels eines als elektrisch leitfähige Verbindung ausgebildeten Massenbonds 31 mit dem Schaltungsträger 12 verbunden.

Zur elektrischen Verbindung dieser Leiterbahn 20 mit dem Gehäuse 2 ist der mit ihr elektrisch verbundene Kontaktstift 25 der Schnittstelle 23 elektrisch leitend mit der Schraube 6 verbunden.

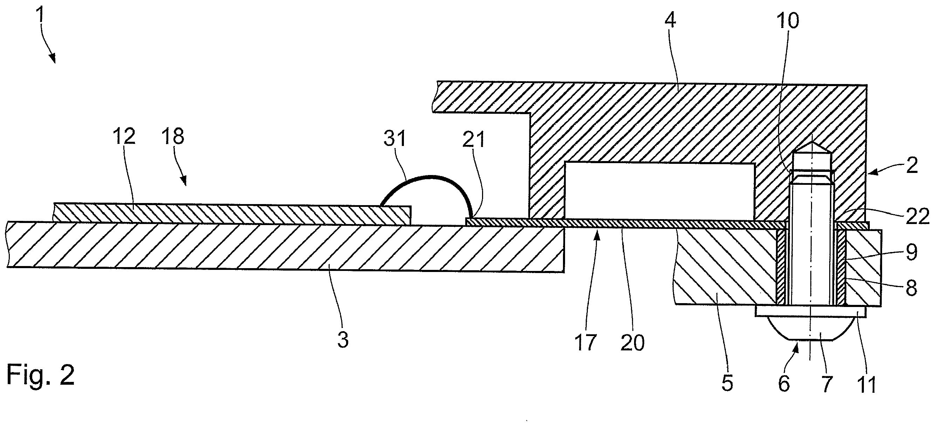

Bei dem Ausführungsbeispiel gemäß Fig. 2 ist die Leiterbahn 20 zum Potentialausgleich zwischen dem Schaltungsträger 12 und dem Gehäuse 2 an der zweiten Kontaktstelle 22 direkt mit dem Gehäuse 2 elektrisch leitend verbunden. Sie ist insbesondere zwischen dem Deckel 5 und der Seitenwand 4 eingepresst und weist darüber hinaus über die Hülse 9 eine elektrisch leitende Verbindung mit der Schraube 6 auf.

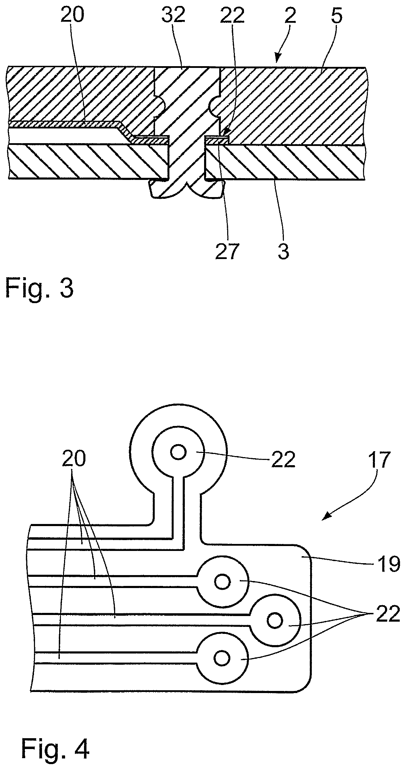

Bei der Ausführungsform gemäß Fig. 3 ist die Leiterbahn 20 zum Potentialausgleich zwischen dem Schaltungsträger 12 und dem Gehäuse 2 direkt mittels eines elektrisch leitfähigen Niets 32, mittels welchem der Deckel 5 mit der Grundplatte 3 verbunden ist, elektrisch leitend verbunden. Selbstverständlich kann hierbei die Nietverbindung auch zwischen zwei anderen, beliebigen Bestandteilen des Gehäuses 2 vorgesehen sein.

Im Folgenden wird die Herstellung eines Potentialausgleichs im Steuergerät 1 beschrieben. Zunächst wird das Steuergerät 1 mit dem elektrischen Bauteil 18, insbesondere mit dem Schaltungsträger 12, dem eine Trägerstruktur umfassenden Gehäuse 2 und der Leiterstruktur 17, welche in datenübertragender Weise mit dem Steuergerät 1 verbunden ist, bereitgestellt. Sodann wird sichergestellt, dass mindestens eine der Leiterbahnen 20 auf der Leiterstruktur 17 elektrisch leitend mit dem Schaltungsträger 12 verbunden ist. Hierzu wird insbesondere der Massebond 31 mit der ersten Kontaktstelle 21 einer der Leiterbahnen 20 sowie mit dem Schaltungsträger 12 elektrisch leitend verbunden, insbesondere verlötet. Sodann wird ein elektrischer Kontakt zwischen der mit dem Schaltungsträger 12 elektrisch leitend verbundenen Leiterbahn 20 und der Trägerstruktur, insbesondere dem Gehäuse 2, hergestellt. Hierzu wird die zweite Kontaktstelle 22 mit einem der Kontaktstifte 25 der Schnittstelle 23, welcher seinerseits mit dem Gehäuse 2 elektrisch leitend verbunden ist, elektrisch leitend verbunden, insbesondere verlötet. Alternativ hierzu kann der elektrische Kontakt zwischen der zweiten Kontaktstelle 22 und dem Gehäuse 2 auch durch Einklemmen der Kontaktstelle 22 im Gehäuse 2, beispielsweise zwischen dem Deckel 5 und der Seitenwand 4, insbesondere im Bereich der Schraube 6, hergestellt werden. Vorteilhafterweise kommt es hierbei zu mindestens zwei Kontaktpunkten zwischen der Kontaktstelle 22 und dem Gehäuse 2, nämlich einem direkten Kontakt durch das Anpressen der Leiterstruktur 17 an das Gehäuse 2 einerseits und zu einem Kontakt mittels der Hülse 9 und der Schraube 6 andererseits.

Im Folgenden wird die Erfindung noch einmal mit anderen Worten beschrieben. Identische Teile erhalten dieselben Bezugszeichen wie bei der vorhergehenden Beschreibung. Funktionell gleichwertige Teile erhalten dieselben Bezugszeichen mit einem nachgestellten a. In der vorliegenden Erfindung ist das Steuergerät 1 in der so genannten Standardtechnik aufgebaut. Es umfasst die Grundplatte 3 aus Aluminium und ein Keramiksubstrat als Schaltungsträger 12. Darauf wird das Gehäuse 2, insbesondere ein Tragkörper, aus Kunststoff mit einem Stanzgitter, Hallsensoren und einem oder mehreren Steckern genietet. Der Schaltungsraum 13a wird mit dem Kunststoffdeckel 5a verschlossen. Für Zuleitungen ist die Leiterfolie 17a vorhanden, wobei für die elektrische Verbindung derselben zur Grundplatte 3 eine Nietung, Schraubung oder Klemmung nutzbar ist, die ebenfalls vorhanden ist. Der Prozess des Waschens der Grundplatte 3 kann somit erfindungsgemäß gespart werden. Bei der neuen Masseanbindung geht man mit dem Massebond 31 nicht mehr direkt auf die Grundplatte 3 und erspart sich somit eine mechanische Bearbeitung an dieser Stelle und das Waschen mit Perchlorethylen. Der Massebond 31 geht, wie weitere Bondverbindungen auch, direkt auf die Leiterfolie 17a und stellt über die Leiterfolie 17a eine elektrische Verbindung zur Grundplatte 3 her. Dies kann mit der Masseschraube 6a direkt auf die Leiterfolie 17a geschehen, oder über das angelötete Stanzgitter 24 und die Masseschraube 6a.

Die gefaltete und verklebte Leiterfolie 17a hat dabei zwei Berührungspunkte mit der Grundplatte 3: einmal durch Anpressen der Leiterfolie 17a und einmal durch den Schraubenkopf 7 über das Gewinde 10 zur Grundplatte 3.

Alternativ hierzu ist eine Bondverbindung auf ein zusätzliches Stanzgitter vorgesehen, welches in das Gehäuse 2, insbesondere in den Tragkörper integriert ist. Die Integration wird derart gestaltet, dass die zusätzliche Stanzbahn 20a in eine vorhandene Stanzgittergruppe eingebettet ist. Das zweite Ende 22a des Stanzgitters wird ringförmig ausgeformt, so dass dieser Ring 27 ein Niet 32 umschließt. Der Ring 27 kann wellenförmig oder fächerförmig angeprägt sein. Bei der Endmontage des Steuergerätes 1, d. h. bei der Befestigung des Gehäuses 2, insbesondere des Tragkörpers mittels des Niets 32 an der Grundplatte 3, wird das Masse-Stanzgitter an die Grundplatte 3 aus Aluminium angedrückt. Das Niet 32 ist aus leitfähigem Material. Die Stanzbahn 20a kann insbesondere aus Kupfer bzw. einer Kupfer-Legierung sein.

## Patentansprüche

1. Steuergerät (1) für ein Kraftfahrzeug umfassend
a. mindestens ein elektrisches Bauteil (18) mit einem Schaltungsträger (12),
b. eine Trägerstruktur, wobei die Trägerstruktur zumindest als Teil eines Gehäuses (2) mit einem Gehäuseinnenraum (13) ausgebildet ist, und
c. mindestens eine Leiterstruktur (17), welche
i. in datenübertragender Weise mit dem elektrischen Bauteil (18) verbunden ist und
ii. mindestens eine mit dem Schaltungsträger (12) und der Trägerstruktur elektrisch verbundene Leiterbahn (20) zum Potentialausgleich zwischen diesen aufweist,
**dadurch gekennzeichnet, dass**
die Leiterbahn (20) eine erste Kontaktstelle (21) im Gehäuseinnenraum (13) und eine zweite Kontaktstelle (22) außerhalb des Gehäuses (2) aufweist, und
im Gehäuseinnenraum (13) eine elektrisch leitfähige Verbindung der Leiterbahn (20) mit dem Schaltungsträger (12) mittels eines Massebonds (31) hergestellt ist.

2. Steuergerät (1) gemäß Anspruch 1, **dadurch gekennzeichnet, dass** die Leiterstruktur (17) flexibel ausgebildet ist.

3. Steuergerät (1) gemäß einem der vorhergehenden Ansprüche, **dadurch gekennzeichnet, dass** die Leiterstruktur (17) als Folienleiter ausgebildet ist.

4. Steuergerät (1) gemäß einem der vorhergehenden Ansprüche, **dadurch gekennzeichnet, dass** die Trägerstruktur als Grundplatte (3) des Gehäuses (2) ausgebildet ist.

5. Steuergerät (1) gemäß Anspruch 4, **dadurch gekennzeichnet, dass** die Leiterstruktur (17) mit dem Gehäuse (2) mechanisch und elektrisch leitend verbunden, insbesondere vernietet, verschraubt oder verklemmt ist.

6. Steuergerät (1) gemäß einem der vorhergehenden Ansprüche, **dadurch gekennzeichnet, dass** der Schaltungsträger (12) eine Leiterplatte, insbesondere mit einem Keramiksubstrat umfasst.

7. Verfahren zur Herstellung eines Potentialausgleichs in einem Steuergerät (1) für ein Kraftfahrzeug umfassend die folgenden Schritte:
a. Bereitstellen eines Steuergeräts (1) mit
i. einem Schaltungsträger (12) und
ii. ein eine Trägerstruktur umfassendes Gehäuse (2),
b. Bereitstellen einer Leiterstruktur (17), welche in datenübertragender Weise mit dem Steuergerät (1) verbunden ist, und
c. Herstellen eines elektrischen Kontakts zwischen dem Schaltungsträger (12) und der Trägerstruktur mittels einer auf der Leiterstruktur (17) angeordneten Leiterbahn (20), wobei die Leiterbahn (20) eine erste Kontaktstelle (21) im Gehäuseinnenraum (13) und eine zweite Kontaktstelle (22) außerhalb des Gehäuses (2) aufweist, und
im Gehäuseinnenraum (13) eine elektrisch leitfähige Verbindung der Leiterbahn (20) mit dem Schaltungsträger (12) mittels eines Massebonds (31) hergestellt wird.

8. Verfahren gemäß Anspruch 7, **dadurch gekennzeichnet, dass** die Leiterstruktur (17) flexibel, insbesondere als Folienleiter ausgebildet ist.

## Claims

1. Controller (1) for a motor vehicle, comprising
a. at least one electrical component (18) with a circuit carrier (12),
b. a carrier structure, wherein the carrier structure is embodied at least as part of a housing (2) with a housing interior (13), and
c. at least one conductor structure (17) which
i. is connected to the electrical component (18) in a data-transmitting fashion, and
ii. has at least one conductor track (20) electrically connected to the circuit carrier (12) and the carrier structure, in order to equalize the potential between said circuit carrier (12) and carrier structure,
**characterized in that**
the conductor track (20) has a first contact point (21) in the housing interior (13) and a second contact point (22) outside the housing (2), and
an electrically conductive connection of the conductor track (20) with the circuit carrier (12) is brought about in the housing interior (13) by means of an earthing bond (31).

2. Controller (1) according to Claim 1, **characterized in that** the conductor structure (17) is embodied in a flexible fashion.

3. Controller (1) according to one of the preceding claims, **characterized in that** the conductor structure (17) is embodied as a film conductor.

4. Controller (1) according to one of the preceding claims, **characterized in that** the carrier structure is embodied as a baseplate (3) of the housing (2).

5. Controller (1) according to Claim 4, **characterized in that** the conductor structure (17) is connected mechanically and electrically conductively to the housing (2), in particular riveted, screwed or clamped.

6. Controller (1) according to one of the preceding claims, **characterized in that** the circuit carrier (12) comprises a conductor plate, in particular with a ceramic substrate.

7. Method for bringing about an equalization of potential in a controller (1) for a motor vehicle, comprising the following steps:
a. making available a controller (1) with
i. a circuit carrier (12) and
ii. a housing (2) comprising a carrier structure,
b. making available a conductor structure (17) which is connected to the controller (1) in a data-transmitting fashion, and
c. bringing about electrical contact between the circuit carrier (12) and the carrier structure by means of a conductor track (20) which is arranged on the carrier structure (17), wherein the conductor track (20) has a first contact point (21) in the housing interior (13), and a second contact point (22) outside the housing (2), and
an electrically conductive connection of the conductor track (20) with the circuit carrier (12) is brought about by means of an earthing bond (31) in the housing interior (13).

8. Method according to Claim 7, **characterized in that** the conductor structure (17) is embodied in a flexible fashion, in particular as a film conductor.

## Revendications

1. Appareil de commande (1) destiné à un véhicule automobile, comprenant
a) au moins un composant électrique (18) doté d'un support de circuit (12),
b) une structure de support, dans lequel la structure de support est réalisée au moins en tant que partie d'un boîtier (2) comportant un espace intérieur de boîtier (13), et
c) au moins une structure conductrice (17) qui
i) est reliée de manière à transmettre des données au composant électrique (18) et
ii) comporte au moins une piste conductrice (20) reliée électriquement au support de circuit (12) et à la structure de support à des fins de compensation du potentiel entre ceux-ci,
**caractérisé en ce que** la piste conductrice (20) comporte un premier point de contact (21) dans l'espace intérieur de boîtier (13) et un deuxième point de contact (22) à l'extérieur du boîtier (2), et
une liaison électriquement conductrice de la piste conductrice (20) au support de circuit (12) est établie dans l'espace intérieur de boîtier (13) au moyen d'une connexion de masse (31).

2. Appareil de commande (1) selon la revendication 1, **caractérisé en ce que** la structure conductrice (17) est réalisée de manière à être flexible.

3. Appareil de commande (1) selon l'une quelconque des revendications précédentes, **caractérisé en ce que** la structure conductrice (17) est réalisée sous la forme d'un conducteur plat.

4. Appareil de commande (1) selon l'une quelconque des revendications précédentes, **caractérisé en ce que** la structure conductrice est réalisée sous la forme d'une plaque de base (3) du boîtier (2).

5. Appareil de commande (1) selon l'une quelconque des revendications précédentes, **caractérisé en ce que** la structure conductrice (17) est reliée mécaniquement et de manière électriquement conductrice au boîtier (2), et est notamment rivetée, vissée ou serrée.

6. Appareil de commande (1) selon la revendication 4, **caractérisé en ce que** le support de circuit (12) comprend une carte de circuit imprimé, comportant notamment un substrat céramique.

7. Procédé d'établissement d'une compensation de potentiel dans un appareil de commande (1) destiné à un véhicule automobile, comprenant les étapes consistant à :
a) fournir un appareil de commande (1) comportant
i) un support de circuit (12) et
ii) un boîtier (2) comprenant une structure de support,
b) fournir une structure conductrice (17) qui est reliée à l'appareil de commande (1) de manière à transmettre des données, et
c) établir un contact électrique entre le support de circuit (12) et la structure de support au moyen d'une piste conductrice (20) disposée sur la structure conductrice (17), dans lequel la piste conductrice (20) comporte un premier point de contact (21) dans l'espace intérieur de boîtier (13) et un deuxième point de contact (22) à l'extérieur du boîtier (2), et une liaison électriquement conductrice de la piste conductrice (20) au support de circuit (12) est établie au moyen d'une connexion de masse (31) dans l'espace intérieur de boîtier (13).

8. Procédé selon la revendication 7, **caractérisé en ce que** la structure conductrice (17) est réalisée de manière à être flexible, notamment sous forme de conducteur plat.
